# EUROPÄISCHE PATENTANMELDUNG

(11) **EP 3 029 431 A1**
(43) Veröffentlichungstag der Anmeldung: **08.06.2016**
(21) Anmeldenummer: 14196248.0
(22) Anmeldetag: 04.12.2014
(51) Int. Cl.: G01F 15/06, G01D 4/00, G01F 15/07, G01F 15/075

(54) **Zähler und Verfahren zur Ermittlung von Zählerständen und Verfahren zur drahtlosen Übertragung von elektrischer Energie**

(71) Anmelder: GWF MessSysteme AG, 6002 Luzern (CH)
(72) Erfinder: Mathis, Peter, 6362 Stansstad (CH); Mettler, Roland, 6003 Luzern (CH); Helfenstein, Markus, 6004 Luzern (CH)
(74) Vertreter: Escher, Jean-Philippe

(57) **Zusammenfassung**

Die Erfindung betrifft einen Zähler mit einem hermetisch gekapselten elektronischen Zählwerk mit mindestens einer Zähleinheit zur Ermittlung von Zählerständen, wobei das hermetisch gekapselte elektronische Zählwerk einen Datenspeicher zur Speicherung der Zählerstände und die Zähleinheit eine Antenne mit definierter Antennenform umfassen und mindestens eine Ausleseeinheit zum Auslesen der Zählerstände aus dem Datenspeicher ausserhalb des hermetisch gekapselten elektronischen Zählwerks angeordnet ist. Die Erfindung betrifft weiterhin ein Verfahren zur Ermittlung von Zählerständen und zur drahtlosen Übertragung von elektrischer Energie. Die Antennenform der Antenne der Ausleseeinheit ist identisch zur Antennenform der Zähleinheit, wobei die kongruente und vorgegebene Positionierung der Antenne der Ausleseeinheit relativ zur Zähleinheit eine effektive drahtlose Energieversorgung der Zähleinheit mittels elektromagnetischer Strahlung durch die Ausleseeinheit und davon unabhängig eine stabile drahtlose Datenkoppelung zur Ermittlung von Zählerständen zwischen Zähleinheit und Ausleseeinheit gewährleistet.

## Beschreibung

Die Erfindung betrifft einen Zähler mit einem hermetisch gekapselten elektronischen Zählwerk mit mindestens einer Zähleinheit zur Ermittlung von Zählerständen, wobei das hermetisch gekapselte elektronische Zählwerk einen Datenspeicher zur Speicherung der Zählerstände und zumindest eine Zähleinheit eine Antenne mit definierter Antennenform umfassen und mindestens eine Ausleseeinheit zum Auslesen der Zählerstände aus dem Datenspeicher ausserhalb des hermetisch gekapselten elektronischen Zählwerks angeordnet werden kann. Des Weiteren betrifft die Erfindung ein Verfahren zur Ermittlung von Zählerständen eines hermetisch gekapselten Zählers mit elektronischem Zählwerk, einer Zähleinheit und einem Datenspeicher zur Speicherung der Zählerstände, wobei die Zähleinheit eine Antenne mit definierter Antennenform umfasst. Weiterhin betrifft die Erfindung ein Verfahren zur drahtlosen Übertragung von elektrischer Energie mittels elektromagnetischer Strahlung für einen hermetisch gekapselten Zähler mit elektronischem Zählwerk und einer Zähleinheit, wobei die Zähleinheit eine Antenne mit definierter Antennenform umfasst.

Zähler von fluiden Ressourcen, wie beispielsweise Wasser- und Gaszähler, werden häufig in unmittelbarer Nähe der Versorgungssysteme der fluiden Ressourcen angeordnet und sind damit zumeist widrigen äusseren Bedingungen, wie Feuchtigkeit, Schmutz und Temperaturschwankungen direkt ausgesetzt. Als Schutz gegen diese widrigen Umgebungsbedingungen wurden in der Vergangenheit häufig mechanische Zählwerke in den Zählern, insbesondere in Wasserzähler, verwendet, welche zuverlässig, kostengünstig und eine lange Betriebsdauer gewährleisten konnten. Nachteilig an mechanischen Zählwerken ist jedoch, dass die Ablesung der Zählerstände vor Ort und hauptsächlich visuell durch eine Person vorgenommen werden muss, was arbeits- und damit kostenintensiv ist.

Aus diesem Grunde sind vielfältige elektronische Zähler im Einsatz, die mit einem Netzwerk verbunden sind, so dass die digitalen Zählerstände der Zähler über das Netzwerk von einer zentralen Datenbank ausgelesen werden können. Diese netzwerkgebundenen Anwendungen werden häufig auch unter dem Sammelbegriff "Smart Metering" zusammengefasst.

Um die Funktionalität der elektronischen Zähler zu gewährleisten, benötigen die elektronischen Zähler einerseits eine Energieversorgung und andererseits müssen die Zähler mittels geeigneter und zuverlässiger Schnittstellen mit dem Netzwerk für die Übermittlung der Zählerdaten verbunden werden. Im Stand der Technik wird bisher die Energieversorgung entweder mittels einer internen Stromquelle, wie einer Batterie, oder mittels einer permanenten elektrischen Versorgung bereitgestellt, wie exemplarisch in der EP0293639A2 beschrieben.

Bei Verwendung einer internen Stromquelle, wie einer internen Batterie, für das elektronische Zählwerk wird die Lebensdauer des elektronischen Zählers hauptsächlich von der Lebensdauer der internen Batterie bestimmt. Um die Stromquelle vor Umwelteinflüssen zu schützen, sind die Stromquelle beziehungsweise die elektronischen Zählwerke meistens hermetisch verkapselt, so dass ein einfacher Austausch der Stromquelle nicht möglich ist und daher Zähler mit einer internen Batterie als Stromquelle nur begrenzt eingesetzt werden. Im Falle einer Energieversorgung und Datenkopplung mittels einer elektrischen Kabel- beziehungsweise Datenverbindung ergeben sich häufig Dichtigkeitsprobleme innerhalb der Kabeldurchführungen aufgrund von Altersprozessen und Ermüdungserscheinungen der verwendeten Materialien, insbesondere des Dichtungsmaterials.

Alternativ sind auch Zähler mit Funkanwendungen bekannt, die zumindest eine drahtlose Datenübertragung aus dem hermetisch gekapselten Zählwerk auf ein ausserhalb des Zählwerks angeordnetes Lesegerät ermöglichen. Zur elektrischen Energieversorgung dieser Zähler mit Funkanwendungen werden jedoch häufig weiterhin interne Stromquellen, wie Batterien, und drahtgebundenen Kabelverbindungen verwendet, wie beispielhaft in der US 2014/0045550 Al beschrieben.

Bekannt sind auch vollständig drahtlose Energieversorgungs- und Datenübertragungssysteme bei Zählern, wie beispielsweise Radio-Frequency Identifcation - kurz RFID - Anwendungen. Hierzu wird ein RFID-Transponder in das hermetisch gekapselte Zählwerk des Zählers integriert, wobei der RFID-Transponder eine Antenne, einen analogen Schaltkreis zum Empfangen und Senden, sowie einen digitalen Schaltkreis und einen permanenten Speicher aufweist. Entsprechend dem mittlerweile standardisierten RFID-Verfahren erzeugt das dem RFID-Transponder zugeordnete Lesegerät ein hochfrequentes elektromagnetisches Wechselfeld, das von der Antenne des RFID-Transponders aufgenommen wird und die Elektronik des RFID-Transponders aktiviert. Das Lesegerät sendet dabei gleichzeitig Kommunikations- und Steuerbefehle, die der RFID-Transponder aufnimmt und weiterverarbeitet. Beispielsweise wird die Erkennung des jeweiligen RFID-Transponders im Lesegerät dadurch gewährleistet, dass der RFID-Transponder die Signalantwort an das Lesegerät codiert und in das eingestrahlte elektromagnetische Feld des Lesegeräts durch Feldschwächung im kontaktfreien Kurzschluss oder gegenphasige Reflexion das elektromagnetische Feld modelliert und damit seine eigene unveränderliche Seriennummer, weitere Daten oder andere vom Lesegerät abgefragte Information übermittelt. Nach der Datenübertragung vom RFID-Transponder auf das Lesegerät wird die Datenkopplung zwischen dem RFID-Transponder und dem Lesegerät mittels eines standardisierten Verfahrens wieder getrennt und anschliessend die Energieübertragung vom Lesegerät unterbrochen.

So beschreibt die JP2008015855A ein RFID-Transpondersystem für einen Zähler mit Kommunikationsfunktionen, wobei die drahtlose und sichere Datenübertragung vom Zähler auf das Lesegerät mittels der gezielten Steuerung der Übertragungsrate des Zählers gewährleistet wird.

Problematisch an bekannten RFID-Transpondersystemen ist jedoch, dass aufgrund unterschiedlicher Positionierungen des Lesegeräts relativ zum RFID-Transponder häufig eine zirkulare Polarisation des hochfrequenten elektromagnetischen Wechselfeldes notwendig ist, was eine hohe Strahlungsenergie des elektromagnetischen Wechselfeldes erfordert und einen langen Zeitraum für Energieübertragung und Datenkopplung zur Folge hat. Zusätzlich absorbieren die fluiden Ressourcen, insbesondere Wasser, die Strahlungsenergie des elektromagnetischen Wechselfeldes, was durch zusätzliche Reflexionen des elektromagnetischen Wechselfeldes an den, zumeist metallischen, Komponenten des Zählers dazu führt, dass nur ein Bruchteil der Strahlungsenergie des elektromagnetischen Wechselfeldes des Lesegeräts den RFID-Transponder erreicht. Daher sind hohe Strahlungsenergien der vom Lesegerät ausgesandten elektromagnetischen Wechselfelder zur Energieübertragung und Datenkopplung mit dem RFID-Transponder notwendig. Selbst bei einer sehr hohen Strahlungsenergie der vom Lesegerät ausgesandten elektromagnetischen Wechselfelder kann bei einer ungünstigen oder veränderlichen Positionierung des Lesegerätes relativ zum RFID-Transponder die drahtlose Energieübertragung beziehungsweise die anschliessende Datenkopplung fehlerhaft sein, was zu einem erneuten Verbindungsausbau und damit zu einer erneuten zeitintensiven Datenkopplung gemäss dem RFID-Standard zwischen Lesegerät und RFID-Transponder führt.

Nachteilig bei den Lösungen im Stand der Technik ist weiterhin, dass die bisherigen kabelgebundenen und drahtlosen Zählersysteme keine effektive Energieversorgung des hermetisch gekoppelten Zählers bei gleichzeitig sicherer und stabiler Datenkoppelung zwischen dem Lesegerät und dem hermetisch gekapselten Zähler gewährleisten. Nachteilig bei den RFID-Transpondersystemen in Zählern ist insbesondere, dass die Energieversorgung des RFID-Transponders nur durch sehr hohe Strahlungsenergien der vom Lesegerät ausgesandten elektromagnetischen Wechselfelder ermöglicht wird, was einen hohen Stromverbrauch der Lesegeräte bedingt. Aufgrund ungenauer und veränderlicher Positionierungen des Lesegeräts relativ zum RFID-Transponder muss die Energie- und Datenkoppelung sehr häufig wiederholt werden, was den Stromverbrauch des Lesegeräts weiter erhöht und die Auslesung der Daten aus dem RFID-Transponder verzögert beziehungsweise verhindert.

Es ist daher eine Aufgabe der Erfindung, die Nachteile des Standes der Technik zu überwinden und einen Zähler bereitzustellen, der eine effektive und stabile Energieversorgung eines hermetisch gekapselten elektronischen Zählwerks während der Datenkopplung zwischen dem hermetisch gekapselten elektronischen Zählwerk und einem externen Lesegerät zur Verfügung stellt sowie eine sichere und stabile Datenkopplung gewährleistet.

Diese Aufgabe wird durch den in den unabhängigen Patentansprüchen offenbarten Zähler mit einem hermetisch gekapselten elektronischen Zählwerk, das offenbarte Verfahren zur Ermittlung von Zählerständen und das offenbarte Verfahren zur drahtlosen Übertragung von elektrischer Energie mittels elektromagnetischer Strahlung gelöst.

Die Erfindung betrifft einen Zähler mit einem hermetisch gekapselten elektronischen Zählwerk mit mindestens einer Zähleinheit zur Ermittlung von Zählerständen, wobei das hermetisch gekapselte elektronische Zählwerk einen Datenspeicher zur Speicherung der Zählerstände und die Zähleinheit eine Antenne mit definierter Antennenform umfassen. Elektronisches Zählwerk im Sinne der vorliegenden Erfindung umfasst ein mechanisches Zählwerk mit einer Ausleseelektronik oder einen vollelektronischen Zähler. Des Weiteren sind unter der Definition Daten im Sinne der vorliegenden Erfindung aktuelle oder vergangene Zählerstände, Identifikationsinformationen des Zählers, der Zähleinheit, der Ausleseeinheit und/oder Informationen zu Betriebszuständen des Zählers, der Zähleinheit und/oder der Ausleseeinheit zusammengefasst. Die Erfindung betrifft weiterhin eine Ausleseeinheit zum Auslesen der Zählerstände aus dem Datenspeicher, die ausserhalb des hermetisch gekapselten elektronischen Zählwerks angeordnet ist und eine Antenne mit korrespondierender Antennenform zur Antennenform der Antenne der Zähleinheit aufweist. Die Ausleseeinheit kann entweder permanent oder temporär mit der Zähleinheit verbunden werden, beispielsweise permanent am Zähler oder temporär als Handlesegerät, das kurzzeitig mit der Zähleinheit verbindbar ist. Die Ausleseeinheit und die Zähleinheit sind dergestalt relativ zueinander positionierbar, dass die Antenne der Ausleseeinheit und die Antenne der Zähleinheit kongruent zueinander angeordnet sind. Aufgrund der identischen Antennenformen der Zähleinheit und der Ausleseeinheit und der kongruenten Anordnungen der Antennen der Ausleseeinheit relativ zur Zähleinheit kann eine sehr effektive Energieübertragung von der Ausleseeinheit auf die Zähleinheit durch die vorliegende Erfindung bereitgestellt werden. Aufgrund der kongruenten Anordnungen der Antennen der Ausleseeinheit und der Zähleinheit ist nach der initialen drahtlosen elektrischen Energieversorgung der Zähleinheit durch die Ausleseeinheit auch eine effektive und stabile Datenkopplung der Zähleinheit mit der Ausleseeinheit über die identischen Antennenformen der Ausleseeinheit und der Zähleinheit möglich, was die notwendige externe Energieversorgung der Zähleinheit auf ein absolut notwendiges Minimum begrenzt. Aufgrund dieser erfinderischen Konzeption des Zählers können auch Lesegeräte als Ausleseeinheiten mit wesentlich geringerer Sendeleistung im Vergleich zu herkömmlichen RFID-Lesegeräten verwendet werden.

Im Sinne der vorliegenden Erfindung wird unter dem Begriff kongruent ein in einer Mehrzahl von Punkten der Antenne der Zähleinheit und der Antenne der Ausleseeinheit übereinstimmende Beabstandung verstanden. Insbesondere sind bei einer kongruenten Anordnung der Antennen die effektive Sendfläche der Antennenform der Ausleseeinheit und die Wirkfläche der Antennenform der Zähleinheit deckungsgleich und auf parallelen Ebenen mit einem geringen Abstand zueinander angeordnet. Beispielsweise kann eine kreisförmige Rundantenne der Zähleinheit bezüglich des gleichen Mittelpunktes relativ zu einer identischen kreisförmigen Rundantenne der Ausleseeinheit in der zugeordneten parallelen Ebene gedreht sein, wobei dabei die Deckungsgleichheit der effektiven Sendefläche der Antenne der Ausleseeinheit mit der Wirkfläche der Antenne der Zähleinheit sich gerade nicht verändert. Die Zähleinheit kann im Sinne der Erfindung mit mehreren Ausleseeinheiten gleichzeitig oder jeweils einzeln und separat verbunden werden. Vorteilhafterweise wird elektrische Energie drahtlos von der Ausleseeinheit auf die Zähleinheit übermittelt, wobei die elektrische Energie von der Antenne der Ausleseeinheit auf die korrespondierende Antenne der Zähleinheit als elektromagnetische Strahlung übertragbar ist. Alternative Energieübertragungsmechanismen unter Ausnutzung der Antennenformen und der relativen Anordnungen der Antennen der Ausleseeinheit und der Zähleinheit, wie beispielsweise eine kapazitive Kopplung sind ebenfalls vom Konzept der vorliegenden Erfindung umfasst. Aber auch die Verwendung einer internen Stromquelle, wie eine Batterie oder einen Kondensator, innerhalb des hermetisch gekapselten Zählwerks, sowie andere bekannten Formen der elektrischen Energieversorgung von Zähler können in Zählersystemen gemäss der vorliegenden Erfindung umgesetzt werden.

Obwohl die Verwendung von korrespondierenden Antennenformen der Ausleseeinheit und der Zähleinheit und deren kongruente Anordnung relativ zueinander für eine drahtlose Energieversorgung der Zähleinheit durch die Ausleseeinheit und die gleichzeitige drahtlose Datenkopplung zwischen der Zähleinheit und der Ausleseeinheit im Besonderen vorteilhaft sind, ist auch die jeweils alleinige Verwendung ausschliesslich zum Zweck der drahtlosen Energieversorgung der Zähleinheit oder separat der Datenkopplung zwischen der Zähleinheit und der Ausleseeinheit im Sinne der Erfindung explizit möglich und vorteilhaft. So kann beispielsweise aufgrund bestimmter Umgebungsbedingungen die Verwendung einer Batterie, eines Akkumulators und/oder nur eines Kondensators als interne Stromquelle der Zähleinheit angezeigt sein, so dass die kongruente Anordnung von korrespondierenden Antennen der Zähleinheit und der Ausleseeinheit ausschliesslich zum Zweck der Datenkopplung und Datenübertragung genutzt wird. Die interne Stromquelle in der Zähleinheit kann für diese Anwendung ebenfalls mittels der drahtlosen Energieübertragung von Ausleseeinheit aufgeladen werden.

Es wird als Vorteil angesehen, dass die Antennenform der Ausleseeinheit und die korrespondierende Antennenform der Zähleinheit kreisförmig sind und den gleichen Kreisradius aufweisen oder als Kreissegmente ausgebildet. Es wird weiterhin als Vorteil angesehen, dass die Antenne der Ausleseeinheit im Gehäuse der Ausleseeinheit und die korrespondierende Antenne der Zähleinheit im Gehäuse der Zähleinheit integriert und die Ausleseeinheit und die Zähleinheit mittels eines Kopplungselements relativ zueinander positionierbar sind. Im Falle der kongruenten Anordnung von kreisförmigen Antennenformen für die Zähleinheit und die Ausleseeinheit wird eine hohe Deckungsgleichheit der effektiven Sendefläche der Ausleseeinheit und der Wirkfläche der Zähleinheit ermöglicht, die einen Wirkungsgrad der drahtlosen Energieübertragung von über 90% ermöglichen. Andere Antennenformen, insbesondere rechteckige Ausgestaltungen, sind ebenfalls vom Erfindungsgedanken umfasst. Die Antenne kann auch nur einen Teil des Glasumfangs ausnutzen oder an anderer Stelle platziert sein. Insbesondere ergibt sich bei einem Kunststoffgehäuse die Möglichkeit, eine beliebige Antennenform an geeigneter Stelle zu platzieren. In Verbindung mit einer festen Einbettung der jeweiligen Antennen in die Gehäuse der Ausleseeinheit und der Zähleinheit, können die Ausleseeinheit und Zähleinheit relative so zueinander positioniert werden, dass die integrierten Antennen kongruent zueinander angeordnet sind. Vorzugsweise liegt der Abstand der Antennen zueinander zwischen 2mm und 10mm, da gerade bei kleinen Abständen der kongruent zueinander angeordneten Antennen der Zäheinheit und der Ausleseeinheit eine sehr effektive drahtlose Energieversorgung und/oder stabile drahtlose Datenkopplung möglich ist. Auch können Kopplungselemente an der Ausleseeinheit und an der Zähleinheit dafür verwendet werden, so dass die Ausleseeinheit und die Zähleinheit jeweils nur in einer genau festgelegten Position zueinander verbindbar sind, beispielsweise mittels einer Schnappkopplung oder durch ein Drehgewinde.

In einer weiteren vorteilhaften Ausgestaltung der Erfindung ist die Ausleseeinheit unmittelbar mit dem Zähler und damit mit der Zähleinheit verbindbar. Die Ausleseeinheit kann dabei entweder permanent oder temporär als Handlesegerät mit der Zähleinheit beziehungsweise mit dem Zähler verbunden werden. Bei der Verwendung von kreisförmigen Antennenformen kann der Durchmesser der kreisförmigen Antennen an den Durchmesser des zumeist ebenfalls kreisförmigen Schauglases des Zählers angepasst werden. Hierdurch ergibt sich die Möglichkeit, innerhalb des hermetisch gekapselten Zählwerks die kreisförmige Antenne der Zähleinheit unterhalb des Schauglases anzuordnen und die kreisförmige identische Antenne der Ausleseeinheit oberhalb des kreisförmigen Schauglases, gegebenenfalls integriert in die Halterung des Schauglases, zu positionieren. Durch diese Zählerkonzeption ist einerseits eine direkte visuelle Ablesung der Zählerstände durch das Schauglas und andererseits eine drahtlose effektive Energieversorgung beziehungsweise Datenkopplung zwischen der Ausleseeinheit oberhalb des Schauglases und der Zähleinheit unterhalb des Schauglases in dem hermetisch gekapselten Zählwerk möglich.

Im Hinblick auf den Datenkopplungsmechanismus wird es als Vorteil angesehen, dass Daten aus dem Datenspeicher der Zähleinheit auf die Ausleseeinheit übermittelbar sind, wobei die Daten von der Antenne der Zähleinheit auf die korrespondierende Antenne der Ausleseeinheit mittels kapazitiver und/oder induktiver Kopplung übertragbar sind. Mittels dieser kapazitiven und/oder induktiven Kopplung können nicht nur Daten von der Zähleinheit an die Ausleseeinheit, sondern auch Steuerungsbefehle, Informationen oder Konfigurationsdateien von der Ausleseeinheit auf die Zähleinheit übermittelt und in der Zähleinheit weiterverarbeitet beziehungsweise abgespeichert werden. Die unterschiedlichen kapazitiven und/oder induktiven Kopplungsverfahren erlauben unter Berücksichtigung der Frequenzbänder der Trägerwelle unterschiedliche Datenübertragungsraten und Verbindungsstabilitäten der drahtlosen Datenkopplung und Datenübertragung zwischen Zähleinheit und der Ausleseeinheit. Auch kann im Rahmen einer kapazitiven und/oder induktiven Datenkopplung eine verschlüsselte Datenübertragung, gegebenenfalls unter Einbeziehung weiterer Datenverarbeitungsgeräte und Netzverbindungen, im Rahmen der Erfindung gewährleistet werden. Auch die Verwendung von gängigen Verbindungsprotokollen und Datenflusssteuerungsverfahren zwischen der Zähleinheit und der Ausleseeinheit, wie beispielsweise die Verwendung von IP-Adressen als Netzwerkprotokolle für die Zähleineinheit oder ein sogenanntes Handshakeverfahren zur Abstimmung der Datenübertragungsrate zwischen den Zähleinheit und der Ausleseeinheit, sind über eine kapazitive und/oder induktive Datenkopplung umsetzbar.

Es wird als Vorteil der vorliegenden Erfindung angesehen, dass die Daten aus dem Datenspeicher der Zähleinheit auf die Ausleseeinheit digital und mit einer gegenüber einem standardisierten Datensatz reduzierten Datenmenge übertragbar sind. Die standardisierten Datensätze und Datenprotokolle gemäss den gängigen technischen Normen, beispielsweise das M-Bus Open Metering System, fordern zumeist die Übertragung einer Vielzahl von Daten von der Zähleinheit auf die Ausleseeinheit, wobei hierdurch unterschiedlichste Anwendungsfälle und verschiedenste Datenkombinationen von den technischen Normen beachtet werden. Für eine Vielzahl von insbesondere Standardanwendungsfällen ist jedoch nicht die vollständige Übertragung aller in der jeweiligen technischen Norm geforderter Daten notwendig. Insofern ist ebenfalls Teil des erfndungsgemässen Konzepts eines Zählers, dass auch Daten mit einer gegenüber einem standardisierten Datensatz einer technischen Norm oder eines technischen Standards reduzierter Datenmenge übertragbar sind. Um einerseits die Zeitdauer der Datenübertragung so gering wie möglich zu halten, andererseits aber die Weiterverarbeitung der Daten aus der Zähleinheit entsprechend den gängigen technischen Normen und Standards zu ermöglichen, ist gemäss der vorliegenden Erfindung vorgesehen, dass die Ausleseeinheit die gegenüber dem standardisierten Datensatz reduzierten Daten mittels einer Zuordnungsfunktion dem standardisierten Datensatz zuordnet und vervollständigt. So ist eine Datenübertragung mit einem gegenüber dem Standard reduzierten Datensatz von der Zähleinheit auf die Ausleseeinheit möglich, gleichzeitig aber auch eine Datenverarbeitung gemäss der technischen Norm oder des Standards aufgrund der Vervollständigung der Daten auf den notwendigen Standarddatensatz der jeweils interessierenden technischen Norm beziehungsweise Standards in der Ausleseeinheit gewährleistet.

Zur Beschleunigung des Auslesevorganges aus der Zähleinheit ist weiterhin vorteilhaft, dass der Datenspeicher der Zähleinheit einen Hauptspeicher und einen Pufferspeicher aufweist und die Daten zwischen dem Hauptspeicher und dem Pufferspeicher bei vorliegender elektrischer Energie synchronisierbar sind, wobei die Daten aus dem Pufferspeicher im Rahmen der Datenübertragung zwischen der Zähleinheit und der Ausleseeinheit auslesbar und übermittelbar sind. Gängige RFID-Speicherarchitekturen verwenden häufig nicht-flüchtige Electrically Erasable Programmable Read-Only Memory (EEPROM), die jedoch langsame Zugriffszeiten und eine nur begrenzte Lebensdauer haben, was deren Verwendung als Datenspeicher in einem hermetisch gekapselten Zählwerk limitiert. Erfindungsgemäss wird daher vorgeschlagen, dass die Daten in einem Random Access Memory (RAM) gespeichert werden, wie beispielsweise Ferroelectric Random Access Memory (FRAM) oder Static Random Access Memory (SRAM), deren Speichereigenschaften durch gezielte Veränderungen der elektrischen Eigenschaften, beispielsweise der ferromagnetischen Eigenschaften bei FRAMs, veränderbar sind. Die Lebensdauer der RAMs, wie beispielsweise FRAMs oder SRAMs, ist nicht begrenzt, so dass der Einsatz von RAMs in einem hermetisch gekapselten Zählwerk vorteilhaft ist. Durch die zusätzliche Unterteilung des RAMs in einen Hauptspeicher und einen noch schnelleren Pufferspeicher können die Daten innerhalb der Zähleinheit bei anliegender elektrischer Energieversorgung im Pufferspeicher schneller im Vergleich zum Hauptspeicher zur Verfügung gestellt und drahtlos an die Ausleseeinheit übertragen werden.

Für eine effektive Datenübertragung bei erfolgter Datenkopplung ist vorteilhafterweise vorgesehen, dass der Datenspeicher der Zähleinheit bei vorliegender elektrischer Energie zuerst die Daten intern aufbereitet beziehungsweise den Zählerstand elektrische ermittelt und nach erfolgter interner Datenaufbereitung eine ausgewählte Speichermarkierung setzt, wobei die Daten der Zähleinheit nur bei gesetzter ausgewählter Speichermarkierung durch die Ausleseeinheit auslesbar sind. Aufgrund des sehr begrenzten Zeitfensters für Datenaufbereitung und Datenübertragung bei einer kurzfristig vorhandener Energieversorgung der Zähleinheit durch die Ausleseeinheit würden umfangreiche und damit zeitaufwendige Datenflusssteuerungsverfahren, wie beispielsweise eine umfangreiche Handshakeprozedur zwischen Zähleinheit und Ausleseeinheit, zu einer fehlerhaften beziehungsweise wiederholten Datenübertragung zwischen der Zähleinheit und der Ausleseeinheit führen. Vorteilhafterweise werden daher gemäss der vorliegenden Erfindung bei vorhandener elektrischer Energieversorgung der Zähleinheit zuerst die Daten intern aufbereitet, beispielsweise der aktuelle Zählerstand elektronisch im Zählwerk ermittelt und im Datenspeicher zur Verfügung gestellt. Erst nach Abschluss dieser internen Datenaufbereitung in der Zähleinheit wird eine ausgewählte Speichermarkierung gesetzt, beispielsweise ein ausgewählter Adressenbereich im Datenspeicher von "busy" auf "ready. Da die elektrische Energieversorgung der Ausleseeinheit nicht problematisch ist, greift die Ausleseeinheit in regelmässigen Zeitabständen auf den ausgewählten Adressenbereich des Datenspeichers zu und initiiert die Datenübertragung erst, wenn der Zustand "ready" als gesetzte Speichermarkierung vorliegt. Die Zeitabstände für die Kontrolle der ausgewählten Speichermarkierung durch die Ausleseeinheit sind in Abhängigkeit von der zu erwartenden Datenmengen, der Datenübertragungsqualität und/oder der Datenübertragungsrate im Auslesegerät frei wählbar.

Zusätzlich erlaubt die reduzierte Datenflusssteuerung der vorliegenden Erfindung eine sofortige Unterbrechung der drahtlosen Energieversorgung der Zähleinheit durch die Ausleseeinheit nach erfolgreicher Datenübertragung, so dass umfangreiche Entkopplungsverfahren zwischen Ausleseeinheit und der Zähleinheit nicht notwendig sind. Nach der Unterbrechung der elektrischen Energieversorgung der Zähleinheit werden die ausgewählten Speichermarkierungen sofort und automatisch wieder zurückgesetzt, beispielsweise auf "busy", so dass eine weitere Datenübertragung nicht mehr möglich ist und Daten im Datenspeicher nicht mehr ausserhalb der Zähleinheit beeinflussbar sind. Die sofortige Unterbrechung der elektrischen Energieversorgung durch die Ausleseeinheit führt auch nicht zu Überspannungen in dem Zählwerk, insbesondere nicht in dem Datenspeicher, so dass Beschädigungen der Zähleinheit bei diesem Vorgehen ausgeschlossen sind.

Vorteilhafterweise ist die Übertragung der Daten aus dem Datenspeicher der Zähleinheit auf die Ausleseeinheit verschlüsselbar, insbesondere mittels gängiger hardware- oder sofwarebasierter Verschlüsselungsmethoden, wie beispielsweise mittels eines Token oder einer PIN-Tastatur am Auslesegerät und/oder Zählers, mit Hilfe einer digitalen Signatur, durch Zertifikate oder mittels einer Public-Key-Verschlüsselung. Weiterhin wird es als Vorteil angesehen, dass die Ausleseeinheit zusätzliche elektronische Bauteile zur Ermittlung und Abstimmung der Impedanz und der Resonanzfrequenz der Antennenform der Zähleinheit für eine optimierte elektrische Energieübertragung von der Antenne der Ausleseeinheit auf die Antenne der Zähleinheit aufweist. Durch diese Massnahmen lässt sich der Wirkungsgrad der Energieübertragung von der Ausleseeinheit auf die Zähleinheit nochmals steigern und optimieren.

Die Erfindung betrifft weiterhin ein Verfahren zur Ermittlung von Zählerständen eines hermetisch gekapselten Zählers mit elektronischem Zählwerk, einer Zähleinheit und einem Datenspeicher zur Speicherung der Zählerstände, wobei die Zähleinheit eine Antenne mit definierter Antennenform umfasst. Nach der Anordnung mindestens einer Ausleseeinheit zum Auslesen der Zählerstände aus dem Datenspeicher ausserhalb des hermetisch gekapselten elektronischen Zählwerks, wobei die Ausleseeinheit eine Antenne mit korrespondierender Antennenform zur Antennenform der Zähleinheit aufweist, wird die Ausleseeinheit relativ zur Zähleinheit positioniert und die Antenne der Ausleseeinheit relativ zur Antenne der Zähleinheit kongruent angeordnet. Sobald eine elektrische Energieversorgung der Zähleinheit gewährleistet ist, wird die Koppelung der Antenne der Zähleinheit mit der korrespondierenden Antenne der Ausleseeinheit vorgenommen und die drahtlose Übertragung der Daten aus dem Datenspeicher der Zähleinheit mittels der Antenne der Zähleinheit auf die die Antenne der Ausleseeinheit initiiert.

Vorteilhafterweise werden die Daten bei vorliegender elektrischer Energie in der Zähleinheit zuerst im Datenspeicher der Zähleinheit aufbereitet und nach erfolgter Datenaufbereitung wird eine ausgewählte Speichermarkierung gesetzt, wobei die Daten der Zähleinheit nur bei gesetzter ausgewählter Speichermarkierung durch die Ausleseeinheit ausgelesen werden können.

Es wird als Vorteil angesehen, dass die Daten mit einer gegenüber einem standardisierten Datensatz, beispielsweise das M-Bus Open Metering System, reduzierten Datenmenge übertragen werden und die gegenüber dem standardisierten Datensatz reduzierten Daten durch die Ausleseeinheit mittels einer Zuordnungsfunktion dem standardisierten Datensatz zugeordnet und vervollständigt werden. Die Daten werden vorteilhafterweise zwischen einem Hauptspeicher und einem Pufferspeicher des Datenspeichers bei vorliegender elektrischer Energie synchronisiert, wobei im Rahmen der Datenübertragung zwischen der Zähleinheit und der Ausleseeinheit die Daten aus dem Pufferspeicher der Zähleinheit ausgelesen und anschliessend an die Ausleseeinheit übermittelt werden.

In einer vorteilhaften Ausgestaltung des Verfahrens ist vorgesehen, dass die elektrische Energie der elektromagnetischen Strahlung von der Antenne der Ausleseeinheit zuerst für die Datenkoppelung der Antenne der Zähleinheit mit der korrespondierenden Antenne der Ausleseeinheit verwendet und gleichzeitig der Zählerstand mittels des elektronischen Zählwerks aufgrund des Vorliegens der elektrischen Energie ermittelt und anschliessend die Daten zwischen dem Hauptspeicher und dem Pufferspeicher des Datenspeichers aufbereitet und synchronisiert werden. Nach Abschluss der Synchronisation der Daten zwischen dem Pufferspeicher und dem Hauptspeicher wird die ausgewählte Speichermarkierung gesetzt und die Ausleseeinheit initiiert die Übertragung der Daten unmittelbar mit Erkennen der ausgewählten Speichermarkierung und unterbricht mit dem Empfang der erwarteten Datenmenge unmittelbar die Übertragung der elektrischen Energie an die Zähleinheit. Hierdurch können einerseits kurze Einschaltzeiten der Zähleinheit bei anliegender elektrischer Energieversorgung durch die Ausleseeinheit eingehalten, andererseits kann eine sichere und schnelle Datenübertragung von der Zähleinheit auf die Ausleseeinheit gewährleistet werden.

Die Erfindung betrifft weiterhin ein Verfahren zur drahtlosen Übertragung von elektrischer Energie mittels elektromagnetischer Strahlung für einen hermetisch gekapselten Zähler mit elektronischem Zählwerk und mindestens einer Zähleinheit, wobei die Zähleinheit eine Antenne mit definierter Antennenform umfasst und mindestens eine Ausleseeinheit ausserhalb des hermetisch gekapselten elektronischen Zählwerks angeordnet ist, wobei die Ausleseeinheit eine Antenne mit korrespondierender Antennenform zur Antennenform der Antenne der Zähleinheit aufweist. Des Weiteren wird die Ausleseeinheit relativ zur Zähleinheit positioniert und eine kongruente Anordnung der Antenne der Ausleseeinheit relativ zur Antenne der Zähleinheit gewährleistet, so dass eine drahtlose Übertragung von elektrischer Energie in Form elektromagnetischer Strahlung von der Antenne der Ausleseeinheit auf die Antenne der Zähleinheit möglich ist.

Weitere vorteilhafte Ausgestaltungen ergeben sich aus den nachfolgenden Figuren und verschiedene Ausführungsbeispiele werden im Folgenden näher erläutert. Es zeigen:
Figur 1: eine Explosionszeichnung einer dreidimensionalen Ansicht des erfindungsgemässen Zählers 1;
Figur 2: eine schematische Aufsicht des erfindungsgemässen Zählwerks 2 mit Zähleinheit 3;
Figur 3a, 3b, 3c: eine Aufsicht auf verschiedene Antennenformen für die Antenne 4 der Zähleinheit 3 und die Antenne 7 der Ausleseeinheit 6;
Figur 4: ein Ablaufdiagramm der Zähleinheit 3 zur Ermittlung von Zählerständen;
Figur 5: eine Übersichtzeichnung der Zuordnungsfunktion 21 bezüglich des übertragenen reduzierten Datensatzes 20 und des standardisierten Datensatzes 19, gemäss den Vorgaben der relevanten technischen Norm.

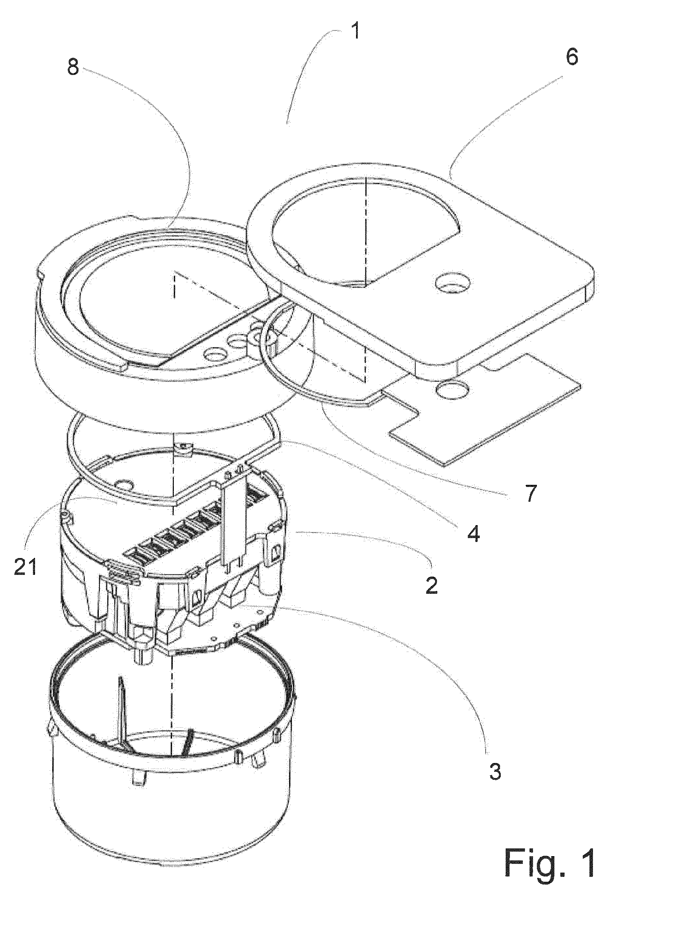

Die Figur 1 zeigt eine perspektivische Schnittzeichnung einer dreidimensionalen Ansicht des erfindungsgemässen Zählers 1 mit einem hermetisch gekapselten elektronischen Zählwerk 2 und mit einer im hermetisch gekapselten elektronischen Zählwerk 2 untergebrachten Zähleinheit 3 zur Ermittlung von Zählerständen. Das hermetisch gekapselte elektronische Zählwerk 2 weist einen Datenspeicher 5 zur Speicherung der Zählerstände auf (nicht in der Fig. 1 gezeigt) und die Zähleinheit 3 umfasst eine Antenne 4 mit einer definierten, gemäss der Ausgestaltung der Erfindung in Fig. 1 als Kreissegment ausgebildeten, Antennenform. Die Antenne 4 der Zähleinheit 3 ist innerhalb der Zähleinheit 3 integriert, vorzugsweise im Aussenbereich der Zähleinheit 3 mit einem Kunststoff vergossen. Alternativ ist auch die Anordnung eines Antennenführungskanals in einem Bereich der Zähleinheit 3 möglich, der eine autarke Wartung und einen Austausch der Antenne 4 der Zähleinheit 3 gewährleistet, ohne das hermetisch gekapselte elektronische Zählwerk 2 zu öffnen.

Mindestens eine Ausleseeinheit 6 zum Auslesen der Zählerstände aus dem Datenspeicher 5 der Zähleinheit 3 ist ausserhalb des hermetisch gekapselten elektronischen Zählwerks 2 angeordnet, vorzugsweise auf der Ober- oder Unterseite des Zählers 1. Die Ausleseeinheit 6 weist eine Antenne 7 mit korrespondierender Antennenform zur Antennenform der Antenne 4 der Zähleinheit 3 auf, wobei im gezeigten Beispiel der Fig. 1 die Antenne 7 der Ausleseeinheit 6 als Kreissegment ausgebildet ist und eine identische Kreissegmentform zur Antenne 4 der Zähleinheit 3 aufweist. Im gezeigten Beispiel der Fig.1 dient die Ausleseeinheit 6 als Glashalterung des von oben sichtbaren Schauglases 21 des Zählers 1 und ist ortsfest und permanent mit dem Zähler 1 verbunden. Die Ausleseeinheit 6 und die Zähleinheit 3 sind aufgrund der ortsfesten, im Beispiel der Fig. 1 gezeigten Steckverbindung als Kopplungselement 8 relativ so zueinander positionierbar, dass die Antenne 7 der Ausleseeinheit 6 und die Antenne 4 der Zähleinheit 3 kongruent zueinander angeordnet sind. Alternativ kann die Ausleseeinheit 6 auch ein Handlesegerät sein, dass mittels eines geeigneten Kopplungselements 8 mit dem Zähler 1 und damit mit der Zähleinheit 3 zeitweise und dennoch genau verbunden werden kann.

Unter dem Begriff kongruente Anordnung wird eine in einer Mehrzahl von Punkten der Antenne 4 der Zähleinheit 3 und der Antenne 7 der Ausleseeinheit 6 übereinstimmende Beabstandung verstanden. Im gezeigten Beispiel der Fig. 1 sind die beiden als Kreissegmente ausgebildeten Antennen 4,7 mit im Wesentlichen gleichen Radien auf jeweils parallelen Ebenen zueinander angeordnet. Wichtig ist bei dieser beispielhaften Anordnung gemäss der Fig. 1, dass die effektive Sendefläche der Antenne 7 der Ausleseeinheit 6 und die Wirkfläche der Antenne 4 der Zähleinheit 3 nahezu deckungsgleich und auf parallelen Ebenen mit einem Abstand von mehr als 2mm zueinander angeordnet sind.

Das hermetisch gekapselte elektronische Zählwerk 2 kann mittels einer zusätzlichen Stromquelle, beispielsweise einer internen Batterie, eines Akkumulators und/oder eines Kondensators, ausgestattet sein, so dass lediglich eine Datenkopplung 12 und eine Datenübertragung 13 zwischen der Antenne 4 der Zähleinheit 3 und der korrespondierenden und kongruent angeordneten Antenne 7 der Ausleseeinheit 6 bereitgestellt wird. Auch ist im Sinne der vorliegenden Erfindung eine ausschliessliche Nutzung der Antennen 4,7 für eine drahtlose elektrische Energieversorgung mittels einer elektromagnetischen Strahlung von Ausleseeinheit 6 auf die Zähleinheit 3 möglich. Die Datenkopplung 12 und Datenübertragung 13 werden in diesem Falle mit anderen externen Datenverarbeitungseinrichtungen vorgenommen, beispielsweise durch ein Datenkabel zwischen der Zähleinheit und einem externen Datenverarbeitungsgerät. Auch die gleichzeitige Nutzung der Antenne 7 der Ausleseeinheit 6 und der Antenne 4 der Zähleinheit 3 für die drahtlose elektrische Energieversorgung und drahtlosen Datenkopplung 12 und Datenübertragung 13 ist wesentlicher Teil der vorliegenden Erfindung.

Da die Zähleinheit 3 und die Ausleseeinheit 6 selbst für kleinste Baugrössen konzeptioniert werden können, da nur eine jeweils korrespondierende Antennenform der Antennen 4,7 und deren kongruente Anordnung sichergestellt sein muss, kann die Zähleinheit 3 und/oder die Ausleseeinheit 6 gegen schon im Betrieb befindliche Zähler 1 ausgetauscht oder nachträglich umgerüstet werden. Die Ausleseeinheit 6 kann mit weiteren Verarbeitungsgeräten und/oder drahtlosen oder kabelgebundenen Netzwerken verbunden sein, die eine Weiterverarbeitung der Daten der Zähleinheit 3 erlauben.

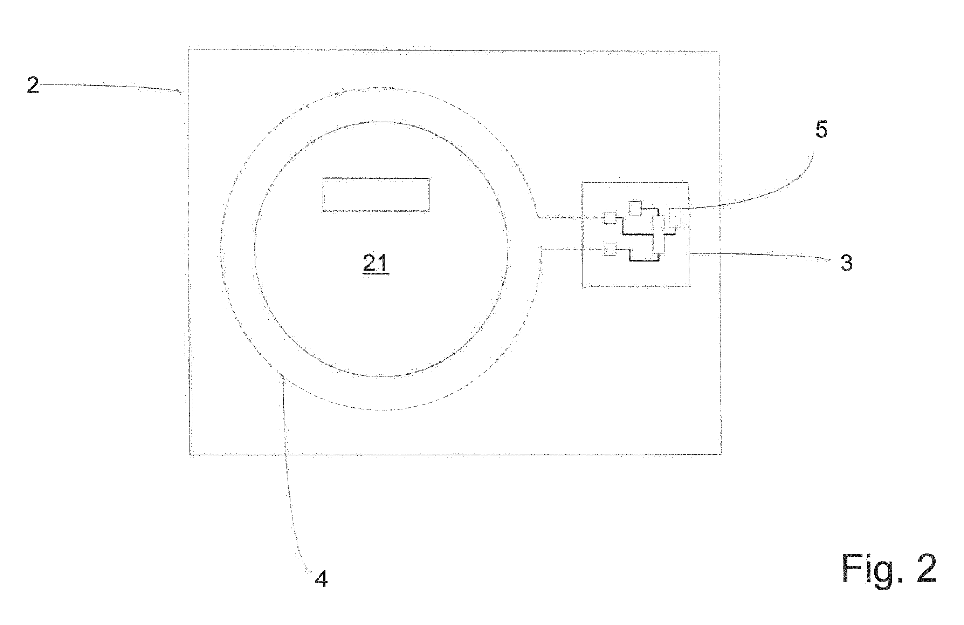

Die Figur 2 zeigt eine schematische Aufsicht des erfindungsgemässen hermetisch gekapselten elektronischen Zählwerks 2 mit Zähleinheit 3. In der Fig. 2 ist das Schauglas 21 mittels durchgezogener Linien und die unterhalb des Schauglases 21 angeordnete Antenne 4 der Zähleinheit 3 als gestrichelte, weil tieferliegende Linie gezeigt. Die Antenne 4 ist unmittelbar mit der ebenfalls unterhalb des Schauglases 21 liegenden Zähleinheit 3 als elektronischer Schaltkreis verbunden und erlaubt somit eine schnelle Datenaufbereitung 14, Datenkopplung 12 und Datenübertragung 13 auf die Ausleseeinheit 6 (nicht in Fig. 2 gezeigt). Gleichzeitig beziehungsweise alternativ ist eine effektive drahtlose Energieübertragung von der Ausleseeinheit 6 auf die Zähleinheit möglich. Selbst bei einem vollständigen elektrischen Ausfall des Zählwerks 2 oder der Ausleseeinheit 6 ist durch die Verwendung eines zusätzlichen Schauglases 21 immer noch eine unmittelbare visuelle Ablesung der Zählerstände möglich, so dass der Zähler 1 im Falle eines elektrischen Systemausfalls nicht unmittelbar auszutauschen wäre.

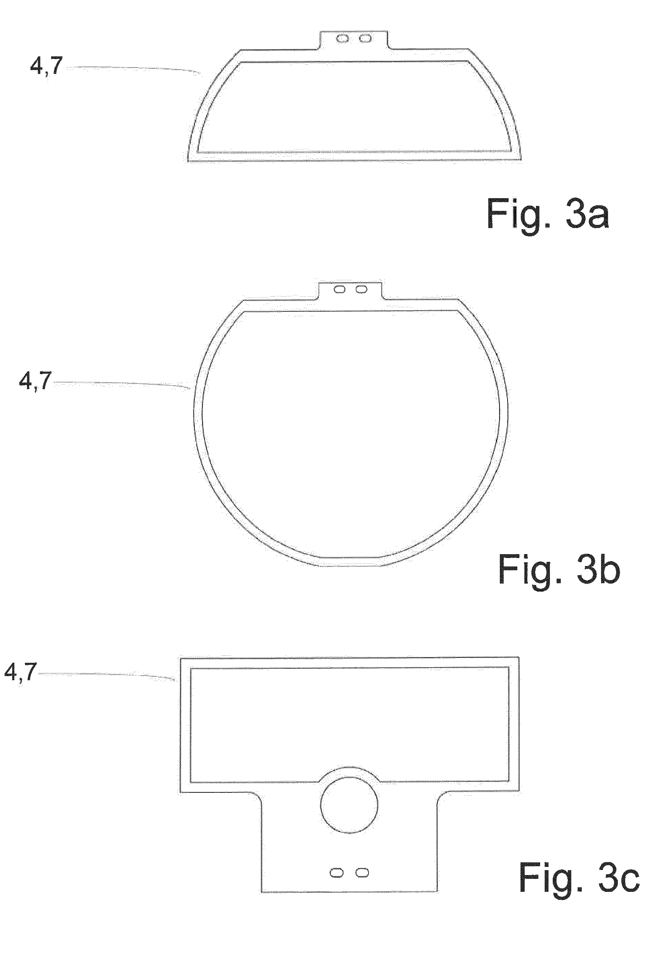

In Abhängigkeit von den baulichen Gegebenheiten für den Zähler 1 an den Versorgungsleitungen, den notwendigen oder vorgegebenen Grössen und Formen der Zähleinheit 3 und der Ausleseeinheit 6 oder den Anschlussmöglichkeiten für die Antenne 4,7 innerhalb der Zähleinheit 3 oder der Ausleseeinheit 6 können unterschiedliche Antennenformen für die Antennen 4,7, wie beispielhaft in den Figuren 3a, 3b und 3c gezeigt, für die Datenkommunikation zwischen der Zähleinheit 3 und der Ausleseeinheit 6 und/oder für die Energieübertragung von der Ausleseeinheit 6 auf die Zähleinheit 3 verwendet werden.

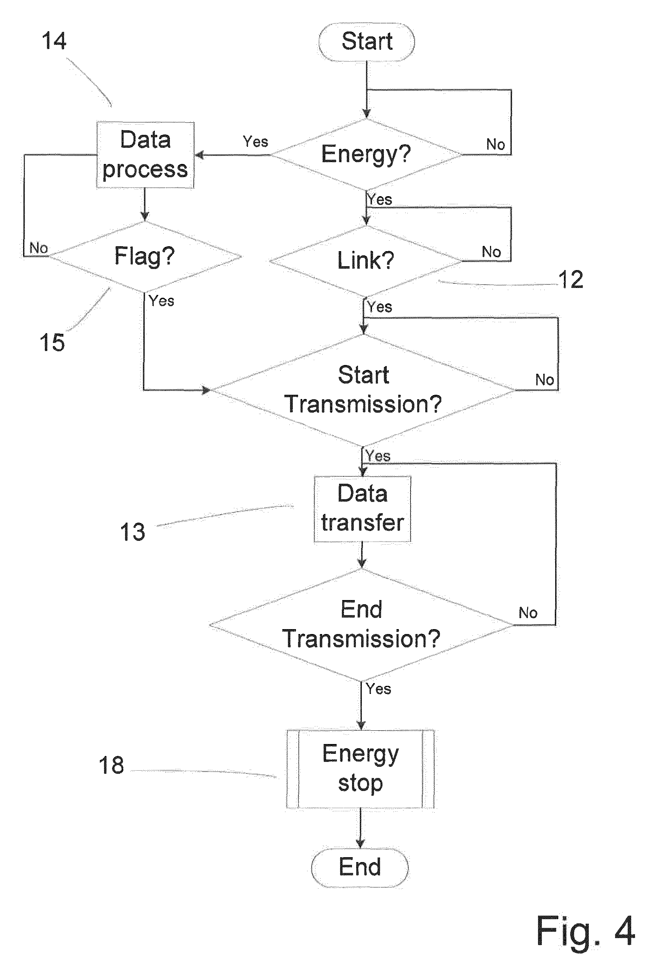

Ein schematisches Ablaufdiagramm zur Ermittlung von Zählerständen in der Zähleinheit 3 ist in der Figur 4 gezeigt. Für den Fall, dass die Zähleinheit 3 (nicht in Fig. 4 gezeigt) an einer permanenten elektrischen Stromversorgung angeschlossen ist, kann die Zähleinheit 3 aktiv das Vorliegen einer elektrischen Energieversorgung überwachen und gegebenenfalls auch aktiv die Datenaufbereitung 14 durchführen beziehungsweise auch die Datenkopplung 12 zur Ausleseeinheit 6 (nicht in Fig. 4 gezeigt) initiieren oder überwachen. Für den Fall, dass die Zähleinheit 3 nicht mit einer eigenständigen elektrischen Energieversorgung verbunden ist und eine drahtlose Energieversorgung durch die Ausleseeinheit 6 benötigt, kann für diesen Fall eine Datenkopplung 12 zwischen der Zähleinheit 3 und der Ausleseeinheit 6 nur initiiert werden, wenn vorher beziehungsweise gleichzeitig die kurzfristig vorhandene elektrische Energie innerhalb der Zähleinheit 3 für die Datenaufbereitung 14 verwendet wurde. Mit Abschluss der Datenaufbereitung 14 wird die ausgewählte Speichermarkierung 15 gesetzt und sollte gleichzeitig eine Datenkopplung 12 vorliegen, wird die Datenübertragung 13 zwischen der Zähleinheit 3 und der Ausleseeinheit 6 gestartet. Nach dem die Ausleseeinheit 6 alle Daten vollständig erhalten hat, kann eine sofortige Unterbrechung der elektrischen Energieversorgung 18 durch die Ausleseeinheit 6 vorgenommen werden, was zu einer sofortigen Abschaltung der Zähleinheit 3 und damit einer Unterbrechung der Datenkopplung 12 führt. Im stromlosen Zustand ist die ausgewählte Speichermarkierung automatisch auf busy" gesetzt, so dass eine weitere Datenübertragung 13 nicht mehr möglich ist und Daten nicht mehr ausserhalb der Zähleinheit 3 beeinflussbar sind. Alternativ kann bei einer permanenten Stromversorgung der Zähleinheit 3 ein koordiniertes Entkopplungsverfahren zwischen der Zähleinheit 3 und der Ausleseeinheit 6 durchgeführt werden und anschliessend versetzt die Zähleinheit 3 sich selbst in einen Niedrigverbrauchmodus.

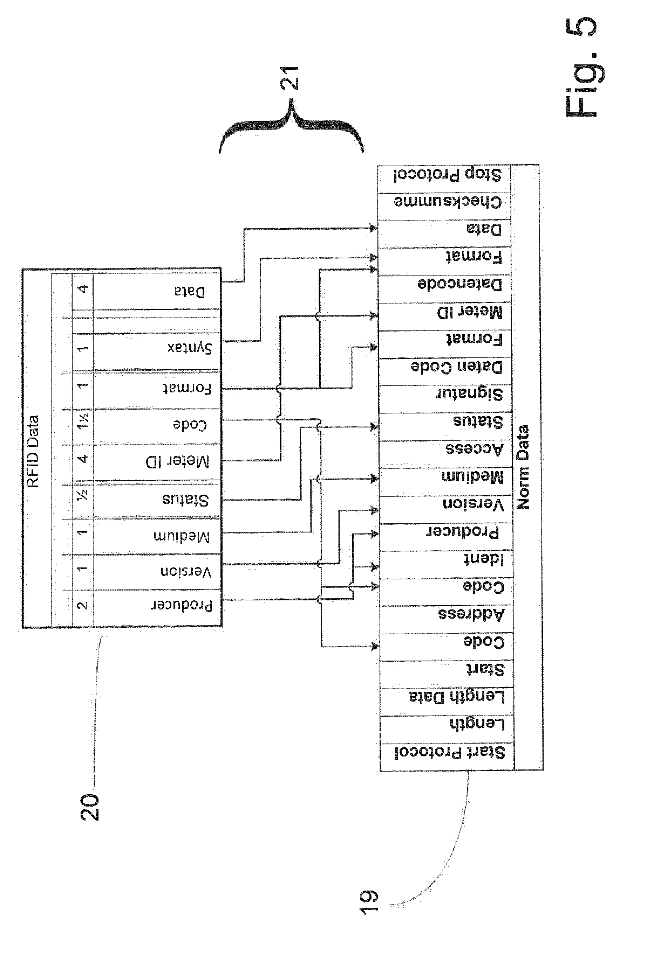

Die Figur 5 zeigt eine Übersichtzeichnung der Zuordnungsfunktion 21 bezüglich des übertragenen reduzierten Datensatzes 20 und des standardisierten Datensatzes 19, gemäss den Vorgaben der relevanten technischen Norm oder Standard. Es wird als vorteilhaft im Sinn der vorliegenden Erfindung gesehen, dass von der Zähleinheit 3 (nicht in der Fig. 5 gezeigt) nur die nötigsten Daten in einer reduzierten Datenmenge 20 an die Ausleseeinheit 6 (nicht in der Fig. 5 gezeigt) übermittelt werden. Zu diesen Daten gehören die zur Laufzeit ermittelten Daten wie Zählerstand und Status. Benötigt werden ebenfalls die zum Zähler gehörenden Daten wie Zählernummer, Einheit, Kommastellen des Zählerstandes, Medium, Hersteller und weitere norm- oder standardabhängige Informationen. Die Ausleseeinheit 6 enthält den der jeweils relevanten technischen Norm oder Standard zugrundeliegenden standardisierten Datensatz 19 und weist über eine vordefinierte Zuordnungsfunktion 21 die Daten der reduzierten Datenmenge 20 dem standardisierten Datensatz 19 zu. Die Zuordnungsfunktion 21 kann dabei in der Ausleseeinheit 6 fest implementiert sein und enthält gegebenenfalls noch weitere Daten und Informationen, die für die Zuordnung beziehungsweise Vervollständigung des standardisierten Datensatzes 19 mittels der reduzierten Datenmenge 20 notwendig sind. So kann beispielsweise bei einer permanenten relativen Anordnung der Zähleinheit 3 und der Ausleseeinheit 6 auf die Übertragung von ortsfesten Daten, wie beispielsweise der Identifkationsnummer oder des Herstellers des Zählers 1 (nicht in Fig. 5 gezeigt) verzichtet werden, da diese Daten sich nicht verändern und immer dem jeweiligen Zähler 1 zugeordnet sind. Zusätzlich beziehungsweise alternativ kann die Ausleseeinheit 6, eventuell in Verbindung über weitere Datenverarbeitungsgeräte und Netzwerke, dynamisch die reduzierte Datenmenge 20 ermitteln und mittels externer Datenbanken die Zuordnungsfunktion 21 dynamisch generieren und damit die reduzierten Datenmenge 20 in Bezug auf den standardisierten Datensatz 19 vervollständigen.

Im gezeigten Beispiel der Fig. 5 werden nur insgesamt Daten der reduzierten Datenmenge 20 mit 16 Bytes übertragen und auf das wesentlich umfangreichere Protokoll des standardisierten Datensatzes 19 des technischen Standards, wie beispielsweise das Standardübertragungsprotokoll des M-Bus Open Metering Systems, angepasst.

## Patentansprüche

1. Zähler (1) mit einem hermetisch gekapselten elektronischen Zählwerk (2) mit mindestens einer Zähleinheit (3) zur Ermittlung von Zählerständen, wobei das hermetisch gekapselte elektronische Zählwerk (2) einen Datenspeicher (5) zur Speicherung der Zählerstände und die Zähleinheit (3) eine Antenne (4) mit definierter Antennenform umfassen und mindestens eine Ausleseeinheit (6) zum Auslesen der Zählerstände aus dem Datenspeicher (5) ausserhalb des hermetisch gekapselten elektronischen Zählwerks (2) anordbar ist, **dadurch gekennzeichnet, dass** die Ausleseeinheit (6) eine Antenne (7) mit korrespondierender Antennenform zur Antennenform der Antenne (3) der Zähleinheit (3) aufweist und die Ausleseeinheit (6) und die Zähleinheit (3) dergestalt relativ zueinander positionierbar sind, dass die Antenne (7) der Ausleseeinheit (6) und die Antenne (4) der Zähleinheit (3) kongruent zueinander angeordnet sind.

2. Zähler (1) nach Anspruch 1, **dadurch gekennzeichnet, dass** elektrische Energie von der Ausleseeinheit (6) auf die Zähleinheit (3) drahtlos übermittelbar ist, wobei die elektrische Energie von der Antenne (7) der Ausleseeinheit (6) auf die korrespondierende Antenne (4) der Zähleinheit (3) als elektromagnetische Strahlung übertragbar ist.

3. Zähler (1) nach einem der Ansprüche 1 oder 2, **dadurch gekennzeichnet, dass** die Antennenform der Antenne (7) der Ausleseeinheit (6) und die korrespondierende Antennenform der Antenne (4) der Zähleinheit (3) kreisförmig sind und den gleichen Kreisradius aufweisen und insbesondere jeweils als identische Kreissegmente ausgebildet sind.

4. Zähler (1) nach einem der Ansprüche 1 bis 3, **dadurch gekennzeichnet, dass** die Antenne (7) der Ausleseeinheit (6) innerhalb der Ausleseeinheit (6) und die korrespondierende Antenne (4) der Zähleinheit (3) innerhalb der Zähleinheit (3) angeordnet und die Ausleseeinheit (6) und die Zähleinheit (3) mittels mindestens eines Kopplungselements (8) relativ zueinander positionierbar sind.

5. Zähler (1) nach einem der Ansprüche 1 bis 4, **dadurch gekennzeichnet, dass** Daten aus dem Datenspeicher (5) der Zähleinheit (3) auf die Ausleseeinheit (6) übermittelbar sind, wobei eine Datenkopplung (12) von der Antenne (4) der Zähleinheit (3) mit der korrespondierenden Antenne (7) der Ausleseeinheit (6) mittels kapazitiver und/oder induktiver Kopplung vornehmbar ist.

6. Zähler (1) nach einem der Ansprüche 1 bis 5, **dadurch gekennzeichnet, dass** die Daten aus dem Datenspeicher (5) der Zähleinheit (3) auf die Ausleseeinheit (6) digital und mit einer gegenüber einem standardisierten Datensatz (19) reduzierten Datenmenge (20) übertragbar sind.

7. Zähler (1) nach Anspruch 6, **dadurch gekennzeichnet, dass** die Ausleseeinheit (6) die gegenüber dem standardisierten Datensatz (19) reduzierte Datenmenge (20) mittels einer Zuordnungsfunktion (21) dem standardisierten Datensatz (19) zuordnet und vervollständigt.

8. Zähler (1) nach einem der Ansprüche 1 bis 7, **dadurch gekennzeichnet, dass** der Datenspeicher (5) der Zähleinheit (3) einen Hauptspeicher (8) und einen Pufferspeicher (9) aufweist und die Daten zwischen dem Hauptspeicher (8) und dem Pufferspeicher (9) bei vorliegender elektrischer Energie synchronisierbar sind, wobei die Daten innerhalb des Pufferspeichers (9) im Rahmen der Datenübertragung (12) zwischen der Zähleinheit (3) und der Ausleseeinheit (6) auslesbar beziehungsweise übermittelbar sind.

9. Zähler (1) nach einem der Ansprüche 1 bis 8, **dadurch gekennzeichnet, dass** der Datenspeicher (5) der Zähleinheit (3) bei vorliegender elektrischer Energie zuerst die Daten intern aufbereitet (14) und nach erfolgter interner Datenaufbereitung (14) eine ausgewählte Speichermarkierung setzt (15), wobei die Daten der Zähleinheit (3) nur bei gesetzter ausgewählter Speichermarkierung (15) durch die Ausleseeinheit (6) auslesbar sind.

10. Zähler (1) nach einem der Ansprüche 1 bis 9, **dadurch gekennzeichnet, dass** die Übertragung der Daten (13) aus dem Datenspeicher (5) der Zähleinheit (3) auf die Ausleseeinheit (6) verschlüsselbar ist.

11. Zähler (1) nach einem der Ansprüche 1 bis 10, **dadurch gekennzeichnet, dass** die Ausleseeinheit (6) zusätzliche elektronische Bauteile (11) zur Ermittlung und Abstimmung der Impedanz und/oder der Resonanzfrequenz der Antennenform der Zähleinheit (3) für eine optimierte elektrische Energieübertragung von der Antenne (7) der Ausleseeinheit (6) auf die Antenne (4) der Zähleinheit (3) aufweist.

12. Verfahren zur Ermittlung von Zählerständen eines Zählers (1), gemäss einem der Ansprüche 1 bis 11, mit hermetisch gekapselten elektronischem Zählwerk (2), mindestens einer Zähleinheit (3) und einem Datenspeicher (5) zur Speicherung der Zählerstände, wobei die Zähleinheit (3) eine Antenne (4) mit definierter Antennenform umfasst, mit folgenden Schritten:
• Anordnung (10) mindestens einer Ausleseeinheit (6) zum Auslesen der Zählerstände aus dem Datenspeicher (5) ausserhalb des hermetisch gekapselten elektronischen Zählwerks (2), wobei die Ausleseeinheit (6) eine Antenne (7) mit korrespondierender Antennenform zur Antennenform der Antenne (4) der Zähleinheit (3) aufweist;
• Positionierung (11) der Ausleseeinheit (6) relativ zur Zähleinheit (3) und kongruente Anordnung der Antenne (7) der Ausleseeinheit (6) relativ zur Antenne (4) der Zähleinheit (3);
• Datenkoppelung (12) der Antenne (4) der Zähleinheit (3) mit der korrespondierenden Antenne (7) der Ausleseeinheit (6) und drahtlose Übertragung der Daten (13) aus dem Datenspeicher (5) der Zähleinheit (3) mittels der Antenne (4) der Zähleinheit (3) auf die die Antenne (7) der Ausleseeinheit (6).

13. Verfahren zur Ermittlung von Zählerständen nach Anspruch 12, **dadurch gekennzeichnet, dass** die Daten bei vorliegender elektrischer Energie in der Zähleinheit (3) zuerst im Datenspeicher (5) der Zähleinheit (3) aufbereitet werden (14) und nach erfolgter Datenaufbereitung (14) eine ausgewählte Speichermarkierung gesetzt wird (15), wobei die Daten der Zähleinheit (3) nur bei gesetzter ausgewählter Speichermarkierung (15) durch die Ausleseeinheit (6) ausgelesen werden können (13).

14. Verfahren zur Ermittlung von Zählerständen nach einem der Ansprüche 12 oder 13, **dadurch gekennzeichnet, dass** die Daten mit einer gegenüber einem standardisierten Datensatz (19) reduzierten Datenmenge (20) übertragen werden (13) und die gegenüber dem standardisierten Datensatz (19) reduzierten Datenmenge (20) durch die Ausleseeinheit (6) mittels einer Zuordnungsfunktion (21) dem standardisierten Datensatz (19) zugeordnet und vervollständigt werden (16).

15. Verfahren zur Ermittlung von Zählerständen nach einem der Ansprüche 12 bis 14, **dadurch gekennzeichnet, dass** die Daten zwischen einem Hauptspeicher (8) und einem Pufferspeicher (9) des Datenspeichers (5) bei vorliegender elektrischer Energie synchronisiert werden (17), wobei im Rahmen der Datenübertragung (13) zwischen der Zähleinheit (3) und der Ausleseeinheit (6) die Daten aus dem Pufferspeicher (9) der Zähleinheit (3) ausgelesen und anschliessend an die Ausleseeinheit (6) übermittelt werden.

16. Verfahren zur Ermittlung von Zählerständen nach einem der Ansprüche 12 bis 15, **dadurch gekennzeichnet, dass** die elektrische Energie der elektromagnetischen Strahlung von der Antenne (7) der Ausleseeinheit (6) zuerst für die Datenkoppelung (12) der Antenne (4) der Zähleinheit (3) mit der korrespondierenden Antenne (7) der Ausleseeinheit (6) verwendet und gleichzeitig der Zählerstand mittels des elektronischen Zählwerks (2) aufgrund des Vorliegens der elektrischen Energie ermittelt und anschliessend die Daten zwischen dem Hauptspeicher (8) und dem Pufferspeicher (9) des Datenspeichers (5) aufbereitet und synchronisiert werden (17), wobei nach Abschluss der Synchronisation der Daten (17) zwischen dem Pufferspeicher (9) und dem Hauptspeicher (8) die ausgewählte Speichermarkierung gesetzt (15) und durch die Ausleseeinheit (6) die Übertragung der Daten (13) unmittelbar mit Erkennen der ausgewählten Speichermarkierung (15) initiiert und mit dem Empfang der erwarteten Datenmenge unmittelbar die Versorgung der elektrischen Energie (18) der Zähleinheit (3) durch die Ausleseeinheit (6) unterbrochen wird.

17. Verfahren zur drahtlosen Übertragung von elektrischer Energie mittels elektromagnetischer Strahlung für einen Zähler (1)), gemäss einem der Ansprüche 1 bis 11, mit hermetisch gekapselten elektronischem Zählwerk (2) und mindestens einer Zähleinheit (3), wobei die Zähleinheit (3) eine Antenne (4) mit definierter Antennenform umfasst, mit folgenden Schritten:
• Anordnung (10) mindestens einer Ausleseeinheit (6) ausserhalb des hermetisch gekapselten elektronischen Zählwerks (2), wobei die Ausleseeinheit (6) eine Antenne (7) mit korrespondierender Antennenform zur Antennenform der Antenne (4) der Zähleinheit (3) aufweist;
• Positionierung (11) der Ausleseeinheit (6) relativ zur Zähleinheit (3) und kongruente Anordnung der Antenne (7) der Ausleseeinheit (6) relativ zur Antenne (4) der Zähleinheit (3);
• drahtlose Übertragung von elektrischer Energie (18) in Form elektromagnetischer Strahlung von der Antenne (7) der Ausleseeinheit (6) auf die Antenne (4) der Zähleinheit (3) zur drahtlosen Versorgung der Zähleinheit (3) mit elektrischen Energie (18).
